# EUROPÄISCHE PATENTSCHRIFT

(11) **EP 2 530 742 B1**
(45) Veröffentlichungstag und Bekanntmachung des Hinweises auf die Patenterteilung: **17.10.2018**
(21) Anmeldenummer: 12169130.7
(22) Anmeldetag: 23.05.2012
(51) Int. Cl.: H01L 31/048, B32B 17/10

(54) **Solarzellenmodul**
Solar cell module
Module de cellules solaires

(30) Priorität: 31.05.2011 DE 102011050776; 25.08.2011 DE 102011052992
(43) Veröffentlichungstag der Anmeldung: 05.12.2012
(73) Patentinhaber: Fraunhofer Gesellschaft zur Förderung der angewandten Forschung e.V., 80686 München (DE)
(72) Erfinder: Nagel, Dr. Henning, 63755 Alzenau (DE); Güldner, Ralf, 63739 Aschaffenburg (DE)

(56) Entgegenhaltungen:
- US-A1- 2008 023 063
- US-A1- 2008 053 516
- US-A1- 2008 210 287
- US-A1- 2009 120 489
- US-A1- 2009 126 781
- Tsuyoshi Shioda: "Volume Resistivity of EVA Encapsulant Sheet", Poster Session during PV Module Reliability Workshop at Golden, CO, Feb. 16th-17th, 2011 , 17. Februar 2011 (2011-02-17), Seiten 1-7, XP002682869, Gefunden im Internet: URL:www1.eere.energy.gov/solar/pdfs/pvmrw2 011_p46_csi_shioda.pdf [gefunden am 2012-09-04]
- Anonymous: "2011 Photovoltaic Module Reliability Workshop Preliminary Agenda", PVMRW at Golden, Colorado, Feb. 16th-17th, 2011 , 2. Juni 2011 (2011-06-02), Seite 8PP, XP002682870, Gefunden im Internet: URL:www1.eere.energy.gov/solar/pdfs/pvmrw2 011_program.pdf [gefunden am 2012-09-05]

## Beschreibung

Die Erfindung bezieht sich auf ein Solarzellenmodul umfassend elektrisch verschaltete Solarzellen mit Front- und Rückseiten,
eine entlang der unmittelbar auf den strahlenzugewandten Frontseiten verlaufende transparente erste Schicht, an die sich frontseitig eine transparente Abdeckung anschließt, sowie
eine entlang der Rückseiten verlaufende und auf diesen aufliegende zweite Schicht, die rückseitig von einer auf diesen aufliegenden zweiten Abdeckung abgedeckt ist, wobei die Abdeckungen Außenseiten des Solarzellenmoduls sind.

Um geeignete Spannungen bzw. Leistungen mit Solarzellen bereitzustellen, mit denen Strahlung in elektrische Energie umgewandelt wird, ist es bekannt, die Solarzellen zu größeren Einheiten, sogenannten Modulen, zu verschalten.

Zur Herstellung entsprechender Solarzellenmodule kann auf eine eine erste Abdeckung bildende Glasscheibe z. B. aus Kalk-Natron-Glas eine transparente Kunststoffschicht aus Ethylen-Vinyl-Acetat (EVA) oder Silicongummi gelegt werden, auf die sodann die verschalteten Solarzellen positioniert werden. Dabei kann es sich um kristalline Solarzellen handeln, die über Verbinder in Reihe oder parallel verschaltet sind. Entlang der Rückseiten der Solarzellen wird sodann eine zweite Kunststoffschicht gelegt, die nach dem Stand der Technik aus dem gleichen Material wie die frontseitig verlaufende Kunststoffschicht besteht.

Sodann wird aus z. B. Polyvinylfluorid (Tedlar) und Polyester eine rückseitige, also zweite Abdeckung gelegt. Anschließend erfolgt ein Laminieren des Moduls entweder bei Unterdruck vorzugsweise im Temperaturbereich von 120 °C bis 160 °C oder in Autoklaven mit Überdruck im gleichen Temperaturbereich. Bei diesem Laminierprozess bildet sich aus den EVA-Folien eine dreidimensional vernetzte und nicht mehr aufschmelzbare Kunststoffschicht, in die Zellen eingebettet und diese fest mit der frontseitigen Abdeckung, also der Glasscheibe, und der rückseitigen Abdeckung verbunden sind.

Entsprechende Solarzellenmodule zeigen gewisse Instabilitäten gegenüber hohen Temperaturen, Temperaturwechselbelastungen und Feuchteeinwirkungen auf. Auch ist eine potentialinduzierte Degradation festzustellen.

Die US-A-2010/0139740 beschreibt ein Solarzellenmodul, dessen Solarzellen von einem Einbettmaterial insbesondere aus Poly-Ethyl-Vinyl-Acetat abgedeckt sind. Entlang des frontseitig verlaufenden Einbettmaterials verläuft eine Isolierschicht, die aus einem fluorhaltigen Polymer besteht. Die Isolierschicht kann ihrerseits von einer weiteren Einbettmaterialschicht oder unmittelbar von einer Glasscheibe abgedeckt sein.

Gegenstand der US-A-5,476,553 ist ein Solarzellenmodul, dessen Solarzellen front- und rückseitig von Schichten abgedeckt sind, die aus einem Ionomer bestehen können.

Der US-A-5,648,325 ist eine Solarzelle zu entnehmen, die front- und rückseitig von einer transparenten Schicht abgedeckt ist.

Die WO-A-2010/054274 bezieht sich auf ein Solarzellenpanel, das front- und rückseitig von einer Vergussmasse abgedeckt ist, die ihrerseits von einem Frontglas bzw. einer Rückseitenschicht abgedeckt ist.

Bei einer Solarzelle nach der US-A-2009/0120489 sind zwischen der Front- und Rückseitenabdeckung eine wärmebeständige Haftschicht und eine Pufferschicht angeordnet, die sich in ihrer Steifigkeit um zumindest 30 MPa unterscheiden.

Um gute Hafteigenschaften zu Laminatschichten für Solarzellen zu erzielen, wird nach der US-A-2008/0053516 eine Schicht aus einem Polyesterfilm vorgeschlagen, von dem zumindest eine Seite mit einem Polyolefin beschichtet ist, die zumindest eine primäre Aminogruppe enthält.

Der Literaturstelle Tsuyoshi Sioda: "Volume Resistivity of EVA Encapsulant Sheet", Poster Session during PV Module Reliability Workshop at Golden, CO, Feb. 16th-17th, 2011, sind spezifische Widerstände von Materialien zu entnehmen, die als Verkapselungsmaterialien für Solarzellen verwendet werden.

Der vorliegenden Erfindung liegt die Aufgabe zu Grunde, insbesondere eine potentialinduzierte Degradation weitgehend zu verhindern bzw. zu minimieren und eine verbesserte Stabilität gegenüber Temperaturwechselbelastungen zu erzielen. Auch soll sich das Eindringen von Feuchtigkeit nicht merklich auf die elektrische Leistung des Moduls auswirken.

Zur Lösung der Aufgabe wird im Wesentlichen vorgeschlagen, dass die erste Schicht aus einem ersten Polymermaterial und die zweite Schicht aus einem von dem ersten Polymermaterial abweichenden zweiten Polymermaterial besteht, dass spezifischer Widerstand ρ₁ des ersten Materials größer als spezifischer Widerstand ρ₂ des zweiten Materials ist, wobei der spezifische Widerstand ρ₁ der ersten Schicht (2) beträgt 5 x 10¹⁶ Ωcm ≤ ρ₁ ≤ 5 x 10¹⁹ Ωcm, gemessen bei 25 °C, und dass Speichermodul G₁' der ersten Schicht (2) größer als Speichermodul G₂' der zweiten Schicht (4) ist, wobei der Speichermodul G₁' der ersten Schicht (2) beträgt G₁' > 8 x 10⁶ Pa gemessen bei 25 °C und 1 Hz, wobei das erste Polymermaterial ein Polyethylen- Polypropylen-Copolymer-Material ist und das zweite Ethylen-Vinyl-Acetat ist.

Überraschenderweise hat sich gezeigt, dass sich dann, wenn das frontseitige, also das der Strahlung zugewandte Einbettmaterial von dem der Rückseite abweicht, Synergieeffekte zwischen den physikalischen und chemischen Eigenschaften der Einbettmaterialien mit der Folge ergeben, dass insbesondere die potentialinduzierte Degradation reduziert wird.

Es kann somit ein Solarmodul im Vergleich zu bekannten Aufbauten mit hoher elektrischer Leistung bei gleichzeitig verbesserter Stabilität gegenüber hohen Temperaturen, Temperaturwechselbelastung und Feuchteeinwirkung zur Verfügung gestellt werden.

Es ist vorgesehen, dass die frontseitig verlaufende erste Schicht einen spezifischen Widerstand rho₁ mit ρ₁ > 5 x 10¹⁶ Ωcm, gemessen bei einer Temperatur von 25 °C aufweist. Dieser spezifische Widerstand herrscht unmittelbar nach der Herstellung des Solarzellenmoduls und schließt einen Zeitraum bis 1 Woche nach der Herstellung ein. Insbesondere beträgt der spezifische Widerstand ρ₁ mit den zuvor genannten Nebenbedingungen von Temperatur und Zeit 5 x 10¹⁶ Ωcm bis 1 x 10¹⁹ Ωcm.

Ist der Speichermodul G₁' der ersten Schicht größer als 8 x 10⁶ Pa, gemessen bei 25 °C und 1 Hz nach Verarbeitung in das Solarzellenmodul, sieht die Erfindung des Weiteren vor, dass das Speichermodul G₂ der rückseitigen, also der zweiten Schicht, kleiner als 8 x 10⁶ Pa bei gleichen Nebenbedingungen ist.

Insbesondere beträgt der Speichermodul G₁' (Speichermodul der ersten Schicht) 8 x 10⁶ Pa < G₁' < 8 x 10⁷ Pa und der Speichermodul G₂' (Speichermodul der zweiten Schicht) 8 x 10⁵ Pa < G₂' < 8 x 10⁶ Pa, gemessen unter Berücksichtigung der zuvor genannten Parameter.

Das EVA (Ethylen-Vinyl-Acetat) Material zur Bildung der zweiten Schicht besitzt einen Speichermodul G' von 3 x 10⁶ Pa. Bei der Verwendung von PE-PP-Copolymer (Polyethylen-Polypropylen-Copolymer) als erste Schicht beträgt das Speichermodul G' 6 bis 8 x 10⁶ Pa.

Der spezifische Widerstand von EVA liegt zwischen 1 x 10¹⁴ Ωcm bis 1 x 10¹⁵ Ωcm. Der spezifische Widerstand von PE-PP-Copolymer beträgt 5 x 10¹⁶ Ωcm. In Bezug auf das zuvor charakterisierte Ionomer ergibt sich ein spezifischer Widerstand zwischen 5 x 10¹⁷ Ωcm und 5 x 10¹⁸ Ωcm. Silicon weist einen spezifischen Widerstand 5 x 10¹⁶ Ωcm auf.

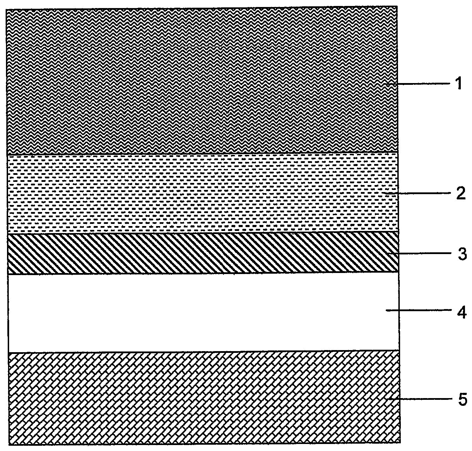

Weitere Einzelheiten, Vorteile und Merkmale der Erfindung ergeben sich nicht nur aus den Ansprüchen, den diesen zu entnehmenden Merkmalen - für sich und/oder in Kombination - , sondern auch aus der nachfolgenden Beschreibung eines der Zeichnung zu entnehmenden bevorzugten Ausführungsbeispiels.

In der einzigen Figur ist rein prinzipiell ein schematischer Aufbau eines Solarzellenmoduls wiedergegeben. So besteht das Solarzellenmodul aus einer frontseitigen stabilen transparenten Abdeckung 1, bei der es sich um ein Kalk-Natron-Glas z. B. einer Dicke zwischen 3 mm und 5 mm, insbesondere im Bereich von 4 mm handeln kann. An die Abdeckung 1 schließt sich eine erste Schicht 2 an, die aus einem PE-PP-Copolymer besteht, das UV-Blocker aufweist.

Die Dicke der ersten Schicht 2 kann im Bereich zwischen 0,3 und 0,7 mm, insbesondere im Bereich von 0,5 mm liegen.

Unabhängig hiervon verläuft die erste Schicht 2 unmittelbar auf den strahlenzugewandten Frontseiten der Solarzellen.

Die erste Schicht 2 deckt die verschalteten Solarzellen 3 ab, die rückseitig von einer zweiten Schicht 4 abgedeckt sind, die aus Ethylen-Vinyl-Acetat besteht. Die Dicke der zweiten Schicht 4 kann der der ersten Schicht 2 entsprechen.

Rückseitig wird die zweite Schicht von einer Polyvinylfluorid-Folie abgedeckt, deren Dicke im Bereich zwischen 1 und 2 mm liegen kann.
Zur Herstellung des Moduls wird zunächst auf die frontseitige Abdeckung 1 die erste Schicht 2 in Form einer Folie aufgelegt, auf die sodann die Solarzellen zur Bildung einer Matrix aufgelegt und verschaltet werden bzw. verschaltete Solarzellen werden auf die die erste Schicht 2 bildende Folie positioniert. Sodann wird zur Bildung der solarzellenrückseitig verlaufenden zweiten Schicht 4 gleichfalls eine Folie aufgelegt, die sodann von der rückseitigen Abdeckung 5 bedeckt wird. Anschließend erfolgt ein Laminieren zu dem Solarzellenmodul bei einer Temperatur insbesondere oberhalb 120 °C.
Das vernetzende Material der zweiten Schicht 4, Ethylen-Vinyl-Acetat, vernetzt bei der verwendeten Laminationstemperatur und verhindert somit ein Verrutschen der die Matrix bildenden Solarzellen während des Laminationsprozesses.

Da die frontseitige, also die erste Schicht 2 bildende Folie aus einem thermoplastischen Material besteht, weist diese bei der verwendeten Laminationstemperatur eine niedrige Viskosität auf.
Der Speichermodul G₂' von EVA gemessen bei 25 °C und 1 Hz beträgt 3 x 10⁶ Pa, so dass die mechanischen Scherspannungen im Modulverbund unter einer kritischen Schwelle verbleiben und die Delamination des Verbundes verhindert wird. Demgegenüber weist die die erste Schicht 2 bildende Folie aus thermoplastischem Material einen wesentlich größeren Speichermodul G₁' auf, der bei der Verwendung von PE-PP-Copolymer als thermoplastisches Material 9 x 10⁶ Pa beträgt. Da die entsprechende aus dem thermoplastischen Material wie PE-PP-Copolymer bestehende und die erste Schicht 2 bildende Folie auf der Front- oder Vorderseite der Solarzellenmatrix verwendet wird, nimmt die frontseitige Abdeckung 1 einen Großteil der Scherspannung auf. Die Scherspannung G₂' der rückseitigen oder zweiten Schicht wie EVA-Schicht belastet hingegen die Solarzellenmatrix und soll deswegen nur einen Speichermodul < 8 x 10⁶ Pa besitzen.

Von Vorteil ist gleichzeitig, dass der spezifische Widerstand der ersten Schicht 2 größer als der der zweiten Schicht 4 ist, so dass die für kristalline Silicium-Solarzellen schädliche potentialinduzierte Degradation verhindert wird.

Bei der Verwendung von PP-PE-Copolymer-Material für die erste Schicht beträgt der spezifische Widerstand 5 x 10¹⁶ Ωcm bei 25 °C, unmittelbar nach der Verarbeitung des Solarzellenmoduls gemessen.

Die rückseitige oder zweite Schicht 4 besteht aus Ethylen-Vinyl-Acetat. Auch in Bezug auf die front- und rückseitige Abdeckungen 1, 5 können gleiche Materialien wie bei dem ersten Beispiel zum Einsatz gelangen.

## Patentansprüche

1. Solarzellenmodul umfassend elektrisch verschaltete Solarzellen (3) mit Front- und Rückseiten,
eine entlang der unmittelbar auf den strahlenzugewandten Frontseiten verlaufende transparente erste Schicht (2), an die sich frontseitig eine transparente Abdeckung (1) anschließt, sowie
eine entlang der Rückseiten verlaufende und auf diesen aufliegende zweite Schicht (4), die rückseitig von einer auf diesen aufliegenden zweiten Abdeckung (5) abgedeckt ist, wobei die Abdeckungen Außenseiten des Solarzellenmoduls sind,
**dadurch gekennzeichnet,**
**dass** die erste Schicht (2) aus einem ersten Polymermaterial und die zweite Schicht (4) aus einem von dem ersten Polymermaterial abweichenden zweiten Polymermaterial besteht, dass spezifischer Widerstand ρ₁ des ersten Materials größer als spezifischer Widerstand ρ₂ des zweiten Materials ist, wobei der spezifische Widerstand ρ₁ der ersten Schicht (2) beträgt 5 x 10¹⁶ Ωcm ≤ ρ₁ ≤ 5 x 10¹⁹ Ωcm, gemessen bei 25 °C, und dass Speichermodul G₁' der ersten Schicht (2) größer als Speichermodul G₂' der zweiten Schicht (4) ist, wobei der Speichermodul G₁' der ersten Schicht (2) beträgt G₁' > 8 x 10⁶ Pa gemessen bei 25 °C und 1 Hz, wobei
das erste Polymermaterial ein Polyethylen-Polypropylen- Copolymer-Material ist und das zweite Polymermaterial Ethylen-Vinyl-Acetat ist.

2. Solarzellenmodul nach Anspruch 1,
**dadurch gekennzeichnet,**
**dass** der Speichermodul G₂' der zweiten Schicht (4) beträgt G₂' < 8 x 10⁶ Pa, gemessen bei 25 °C und 1 Hz.

## Claims

1. Solar cell module comprising electrically interconnected solar cells with frontsides and backsides, a transparent first layer (2) running directly on the front sides facing the radiation, which is followed by a transparent cover (1) on the front, as well as a second layer (4) running along the backsides and resting on them, which is covered at the back by a second cover (5) resting on them, wherein the covers are outer sides of the solar cell module,
**characterized in**
**that** the first layer (2) consists of a first polymer material and the second layer (4) consists of a second polymer material deviating from the first polymer material, that specific resistance ρ₁ of the first material is greater than specific resistance ρ₂ of the second material, wherein the specific resistance ρ₁ of the first layer (2) amounts to 5x10¹⁶ Ωcm ≤ ρ₁ ≤ 5x10¹⁹ Ωcm, measured at 25 °C, and storage module G₁' of the first layer (2) is greater than the storage module G₂' of the second layer (4), wherein the storage module G₁' of the first layer (2) amounts to G₁' > 8x10⁶ Pa measured at 25 °C and 1 Hz, wherein the first polymer material is polyethylene-polypropylene-copolymer material and the second polymer material is ethyl vinyl acetate.

2. Solar cell module according to claim 1,
**characterized in**
**that** the storage module G₂' of the second layer (4) amounts to G₂' < 8x10⁶ Pa, measured at 25 °C and 1 Hz.

## Revendications

1. Module de cellules solaires comprenant des cellules solaires (3) connectées électriquement avec faces avant et arrière, une première couche transparente (2) s'étendant le long des faces avant tournées vers les rayons, á laquelle se rattache un recouvrement transparent (1) sur la face avant, ainsi qu'une deuxième couche (4) s'étendant le long des faces arrière et reposant sur celles-ci, qui est recouverte sur la face arrière d'un deuxième recouvrement (5) reposant sur celles-ci, sachant que les recouvrements constituent les côtés extérieurs du module de cellules solaires,
**caractérisé en ce**
**que** la première couche (2) est constituée d'un premier matériau polymère et la deuxième couche (4) d'un second matériau polymère divergeant du premier matériau polymère, que la résistance spécifique ρ₁ du premier matériau est supérieure à la résistance spécifique ρ₂ du second matériau, sachant que la résistance spécifique ρ₁ de la première couche (2) est telle que 5 x 10¹⁶ Ωcm ≤ ρ₁ ≤ 5 x 10¹⁹ Ωcm, mesurée à 25 °C et que le module de conservation G₁' de la première couche (2) est supérieur au module de conservation G₂' de la deuxième couche (4), sachant que le module de conservation G₁' de la première couche (2) est tel que G₁' > 8 x 10⁶ Pa, mesuré à 25 °C et 1 Hz, sachant que le premier matériau polymère est un copolymère de polyéthylène-polypropylène et que le second matériau polymère est un éthylène-acétate de vinyle.

2. Module de cellules solaires selon la revendication 1,
**caractérisé en ce**
**que** le module de conservation G₂' de la deuxième couche (4) est tel que G₂' < 8 x 10⁶ Pa, mesuré à 25 °C et 1 Hz.
